# EUROPÄISCHE PATENTSCHRIFT

(11) **EP 2 911 311 B1**
(45) Veröffentlichungstag und Bekanntmachung des Hinweises auf die Patenterteilung: **04.04.2018**
(21) Anmeldenummer: 15155766.7
(22) Anmeldetag: 19.02.2015
(51) Int. Cl.: H04B 3/56, H01F 17/06, H03H 1/00, H05K 9/00

(54) **Vorrichtung zum Absorbieren bzw. Reduzieren von Störsignalen auf einem elektrischen Leiter**
Device for absorbing or reducing interference on an electrical conductor
Dispositif destiné à absorber ou à réduire des signaux parasites sur un conducteur électrique

(30) Priorität: 20.02.2014 DE 202014001558 U
(43) Veröffentlichungstag der Anmeldung: 26.08.2015
(73) Patentinhaber: Würth Elektronik eiSos GmbH & Co. KG, 74638 Waldenburg (DE)
(72) Erfinder: Huber, Franz, 5211 Lengau (AT); Lindinger, Gerlinde, 5071 Wals (AT); Schleich, Harald, 83404 Ainring (DE); Quehenberger, Karsten, 5164 Seeham (AT)
(74) Vertreter: Patentanwälte Ruff, Wilhelm, Beier, Dauster & Partner mbB

(56) Entgegenhaltungen:
- DE-A1- 19 730 108
- DE-A1- 19 811 072
- DE-A1- 19 842 323
- DE-A1-102010 042 743
- GB-A- 2 201 840
- JP-A- H0 935 940

## Beschreibung

Die Erfindung betrifft eine Vorrichtung zum Absorbieren bzw. Reduzieren von Störsignalen auf einem elektrischen Leiter nach dem Oberbegriff des Anspruchs 1.

### Stand der Technik

Zum Schützen von elektrischen Geräten vor elektromagnetischen Störsignalen können geteilte Ferritkerne an elektrischen Leitungen des Geräts angebracht werden. Die Ferritkerne müssen die elektrische Leitung vollständig umschließen, damit die Kerne einen geschlossenen Kreis bilden, wodurch eine effektive Entstörung erreicht werden kann.
Bei einer bekannten Ausführungsform wird die Gehäuseverriegelung federnd ausgeführt, was aber zur Folge hat, dass die Gehäuse teilweise nicht vollständig schließen. Bei einer anderen Ausführungsform stehen Gehäusehälften nicht unter Vorspannung, wodurch ebenfalls ein geschlossener Ferritkernkreis nicht gewährleistet ist, was eine unzureichende Entstörung mit sich bringt. Verschiedene bekannte Ausführungsformen sind unter anderem in der DE 197 30 108 A1, der DE 10 2010 042743 A1, der DE 198 42 323 A1, der GB 2 201 840 A, der JP H09 35940 A, sowie der DE 198 11 072 A gezeigt.

### Aufgabe und Vorteile der Erfindung

Der Erfindung liegt die Aufgabe zugrunde, eine Vorrichtung der einleitend bezeichneten Art bereitzustellen, mit welcher sich eine vergleichsweise verbesserte Entstörung von elektronischen Geräten erreichen lässt. Diese Aufgabe wird durch die Merkmale des Anspruchs 1 gelöst.

In den abhängigen Ansprüchen sind vorteilhafte und zweckmäßige Ausgestaltungen der Erfindung angegeben.

Die Erfindung geht von einer Vorrichtung zum Absorbieren bzw. Reduzieren von Störsignalen auf einem elektrischen Leiter, insbesondere einem Kabel aus. Die Vorrichtung umfasst eine Durchführungsöffnung, die zur Durchführung des elektrischen Leiters vorgesehen ist, eine Dämpfungseinrichtung, die ein mehrteiliges, insbesondere zweiteiliges ringförmiges Dämpfungselement aus einem Dämpfungsmaterial umfasst, das elektromagnetische Störsignale, insbesondere Rauschsignale dämpft, und ein Gehäuse, in dem sich das Dämpfungselement unterbringen lässt und das zur Anbringung des Dämpfungselements am elektrischen Leiter vorgesehen ist, wobei das Gehäuse mehrere, insbesondere zwei schalenförmige Gehäuseteile umfasst, wobei in einem zusammengesetzten Zustand der Vorrichtung das Dämpfungselement im Gehäuse einen in der Durchführungsöffnung angeordneten Leiter ringförmig umgibt.

Ein vorteilhafter Aspekt der Erfindung liegt darin, dass an einem innenseitigen Oberflächenabschnitt wenigstens eines der Gehäuseteile eine kissenförmige Einlage angebracht ist, die im zusammengesetzten Zustand der Vorrichtung zwischen dem Gehäuse und dem Dämpfungselement angeordnet ist, wobei die kissenförmige Einlage auf ein Dämpfungsteil des Dämpfungselements drückt und wobei die Einlage aus einem weicheren Material als die Gehäuseschale hergestellt ist. Ringförmig ist im Sinne des Anspruchs insbesondere als rohrförmig zu verstehen, wobei ein Dämpfungsteil z. B. in der Form eines Rohrsegments, insbesondere einer Rohrhalbschale vorliegt.

Durch das Kissenelement können im geschlossenen Zustand des Gehäuses insbesondere zwei Dämpfungsteile an Stoßflächen gegeneinander gedrückt werden, wodurch eine spaltfreie, insbesondere rohrförmige "Ummantelung" eines Kabels realisierbar ist, was eine effektive Unterdrückung von elektromagnetischen Störsignalen ermöglicht.

In einer besonders bevorzugten Ausgestaltung der Erfindung besteht die kissenförmige Einlage aus einem elastischen Material, insbesondere aus einem elastischen Klebemittel, mit dem ein Dämpfungsteil des Dämpfungselements am Gehäuse, insbesondere am Gehäuseteil angebracht ist. Damit lässt sich mit der kissenförmigen Einlage nicht nur ein Dämpfungsteil am Gehäuse fixieren, sondern dieses auch gegenüber dem Gehäuse elastisch, federnd lagern, sodass z. B. zwei Dämpfungsteile in der Form von insbesondere Rohrhälften an einer Stoßstelle dicht schließend zusammendrücken.

In einer überdies vorteilhaften Ausgestaltung der Erfindung ist zumindest ein Gehäuseteil und die kissenförmige Einlage derart ausgebildet, dass das Dämpfungsteil in einem geöffneten Zustand der Vorrichtung über eine Schließkante des Gehäuseteils übersteht, insbesondere aus dem Gehäuseteil hervorstehend angeordnet ist.

Damit kann erreicht werden, dass nach dem Schließen des Gehäuses, das z. B. aus zwei Gehäuseschalen besteht, das überstehende Dämpfungsteil und gegebenenfalls ein zweites, ebenfalls überstehendes Dämpfungsteil oder ein zweites zumindest bündiges Dämpfungsteil oder nicht so weit zurückgesetztes Dämpfungsteil wie das erste Dämpfungsteil übersteht, an den Stoßflächen der Dämpfungsteile dicht aneinander liegen, wobei das elastische Kissen insbesondere auf beide Dämpfungsteile Druck ausübt.

Ein wesentlicher Aspekt der Erfindung liegt darin, dass ein erstes der Gehäuseteile ein nachgiebiges, armförmiges Stützelement aufweist, das an das Dämpfungsteil derart angepasst ist, dass das erste Dämpfungsteil in einem zusammengesetzten Zustand der Vorrichtung an einem zweiten Dämpfungsteil in einer vorgegebenen Position anliegt. Vorzugsweise sind mehrere, insbesondere zwei derartige armförmige Stützelemente vorgesehen, zwischen welchen das erste Dämpfungsteil liegt und sozusagen nicht nur positionsgenau, sondern auch gefedert von den armförmigen Stützelementen gehalten wird. Ein zweites Dämpfungsteil kann in dem anderen Gehäuseteil entsprechend positioniert und federnd gehalten sein. Insbesondere, wenn die Positionierung in einer Weise vorgenommen wird, dass im Hinblick auf eine Schließkante der Gehäuseteile ein Überstand der Dämpfungsteile entsteht, werden die Dämpfungsteile beim Schließen in den armförmigen Stützelementen oder zumindest ein Dämpfungsteil im armförmigen Stützelement federnd zurückgedrängt, sodass die Dämpfungsteile dicht aneinanderliegend nach dem Schließen des Gehäuses positioniert sind.

Der dichte Abschluss von insbesondere zwei halbschalenförmigen Dämpfungsteilen stellt eine effektive Entstörung von unerwünschten elektromagnetischen Signalen sicher.

Im Weiteren ist es bevorzugt, wenn zumindest ein Dämpfungsteil eine Eingreifkontur aufweist, in welche das armförmige Stützelement eingreift, z. B. auch einschnappt, sodass das Dämpfungsteil auch bei geöffnetem Gehäuse positionssicher in einer z. B. Gehäusehälfte gehalten ist, durch die eingeschnappten Stützelemente.

Ein weiterer vorteilhafter Aspekt der Erfindung liegt darin, dass ein erstes Dämpfungsteil zwei erste Anschlagflächen aufweist, die trichterförmig auf einen ersten Oberflächenabschnitt der Durchführungsöffnung am ersten Dämpfungsteil zusammenlaufen, und dass ein zweites Dämpfungsteil zweite Anschlagflächen aufweist, die keilförmig auf einen zweiten Oberflächenabschnitt der Durchführungsöffnung am zweiten Dämpfungsteil zusammenlaufen, wobei in einem der Gehäuseteile, das zur Aufnahme des ersten Dämpfungsteils vorgesehen ist, an einander gegenüberliegenden Flächenbereichen einer Innenseite nachgiebige Stege derart hervorstehend angeordnet sind, dass in einem zusammengesetzten Zustand der Vorrichtung das erste Dämpfungsteil und das zweite Dämpfungsteil passend zueinander aneinander anliegend, drückend positioniert sind. Das erste Dämpfungsteil hat vorzugsweise die Form eines Rohres, aus welchem ein Rohrsegment herausgeschnitten ist, wobei das zweite Dämpfungsteil dann die Form des herausgeschnittenen Segments aufweist. Der im Schnitt trichterförmige Verlauf der Anschlagflächen des ersten Dämpfungsteils ist dabei auf den keilförmigen Verlauf der zweiten Anschlagflächen des zweiten Dämpfungsteils abgestimmt, dass beide Teile derart aneinander gesetzt werden können, dass ein spaltfreies Rohrelement entsteht. Die nachgiebigen Stege sorgen dann dafür, dass die Dämpfungsteile aufeinandergepresst sind, sodass eine Spaltbildung zwischen den Teilen unterbunden wird.
In einer besonders bevorzugten Ausgestaltung der Erfindung sind die Stege wandförmig, sodass sie über eine größere Fläche, insbesondere federnd nachgiebig ein Dämpfungsteil im Gehäuseteil aufnehmen.
Zur einfachen Herbeiführung eines verschlossenen Gehäuses wird im Weiteren vorgeschlagen, dass Verschlussmittel vorgesehen sind, mit denen sich das Gehäuse nach einem Zusammensetzen der Gehäuseteile verschließen lässt.
Für einen einfachen Aufbau des Gehäuses wird im Weiteren vorgeschlagen, dass zwei der schalenförmigen Gehäuseteile über ein Scharnier, insbesondere ein Filmscharnier, miteinander beweglich verbunden sind. Die Gehäuseteile können gegebenenfalls als ein zusammenhängendes Bauteil hergestellt sein, die an einer filmartigen Materialverjüngung miteinander zusammenhängen.
Im Weiteren ist es bevorzugt, wenn an zwei der schalenförmigen Gehäuseteile Verschlussmittel ausgebildet sind, mit denen sich die Gehäuseteile aneinander anschlagend, vorzugsweise dicht verschließen lassen. Damit lässt sich eine einheitliche Oberfläche eines verschlossenen Gehäuses erzielen.
Außerdem vorteilhaft ist es, wenn mit den Verschlussmitteln ein Rastverschluss ausgebildet ist. Der Rastverschluss kann z. B. hakenförmige Vorsprünge an einem Gehäuseteil aufweisen, die in entsprechend angepasste Eingriffsausnehmungen an einem weiteren, insbesondere zweiten Gehäuseteil eingreifen können.

Im Weiteren ist es denkbar, dass eines der Gehäuseteile eine Einstecköffnung aufweist, die zum Einstecken eines darauf abgestimmten Schlüssels vorgesehen ist, mit dem sich die Verschlussmittel öffnen, insbesondere entriegeln lassen. Dazu kann z. B. ein gesondert vorgefertigter Schlüssel dienen oder gegebenenfalls ein gewöhnliches Werkzeug, wie z. B. ein Schraubendreher.

In einer einfachen Ausgestaltung sind die schalenförmigen Gehäuseteile als zwei, insbesondere gleich große Rohrhälften ausgebildet, die an ihren Enden jeweils einen Bund aufweisen, um die Durchführungsöffnung zu definieren.

In einer überdies bevorzugten Ausgestaltung der Erfindung sind zu einer sicheren Positionierung und Fixierung der Dämpfungsteile im jeweiligen Gehäuseteil am ersten Dämpfungselement Rasteingriffe ausgebildet, die für einen Eingriff von Halteklauen an einer Innenseite des ersten Gehäuseteils vorgesehen sind, mit denen das erste Dämpfungselement nach einem Eindrücken im ersten Gehäuseteil zurückgehalten ist. Mit den "Dämpfungsteil-Halteklauen" lassen sich Spannkräfte und Verformungen am Gehäuse und an den Verschlussmitteln begrenzen. Vorzugsweise ist eine Anbringung nicht nur eines ersten Dämpfungsteils am ersten Gehäuseteil in dieser Weise ausgeführt, sondern auch die Fixierung eines zweiten Dämpfungsteils an einem zweiten Gehäuseteil, wobei das Gehäuse bevorzugt aus zwei Gehäuseteilen besteht, in welchen zwei Dämpfungsteile angeordnet sind.

Um eine definierte Bewegung der Gehäuseteile zueinander zu gewährleisten, wird im Weiteren vorgeschlagen, dass zwischen den Gehäuseteilen eine lineare Schiebeführung realisiert ist. Diese kann z. B. auch eine Art Zahnstange umfassen, an welcher ein entsprechendes Gegenelement entlang verschiebbar ist, um so ein über Rastschritte definiertes Zusammenfahren des Gehäuses zu ermöglichen und das geschlossene Gehäuse durch die Rastmittel geschlossen zu halten.

### Beschreibung der Ausführungsbeispiele

Mehrere Ausführungsbeispiele der Erfindung sind in den Zeichnungen dargestellt und unter Angabe von weiteren Einzelheiten und Vorteilen nachstehend näher beschrieben.

Es zeigen
- Figuren 1a bis 1c: ein erstes Ausführungsbeispiel mit Gehäuse in aufgeklappter Draufsicht ohne Ferritkernhälften (Figur 1a), in aufgeklappter perspektivischer Ansicht mit Ferritkernhälften (Figur 1b) und in einer Schnittansicht in geschlossenem Zustand mit Ferritkernhälften (Figur 1c),
- Figuren 2a bis 2c: ein zweites Ausführungsbeispiel eines Gehäuses mit Ferritkernhälften in einer geschlossenen Schnittansicht (Figur 2a), in einer leicht geöffneten Schnittansicht (Figur 2b) und in einer geschlossenen perspektivischen Ansicht mit eingestecktem Schlüssel (Figur 2c),
- Figur 3a und 3b: eine dritte Ausführungsform eines Gehäuses mit Ferritkernhälften, in zwei perspektivischen Ansichten,
- Figur 4: eine Schnittansicht der Ausführungsformen gemäß Figur 3a und 3b entlang einer Achse der Durchführungsöffnung und
- Figuren 5a bis 5c: eine vierte Variante eines Gehäuses mit Ferritkernelementen in einer geschnittenen Seitenansicht (Figur 5a), in einer geöffneten perspektivischen Darstellung (Figur 5b) und in einer geschlossenen perspektivischen Darstellung (Figur 5c).

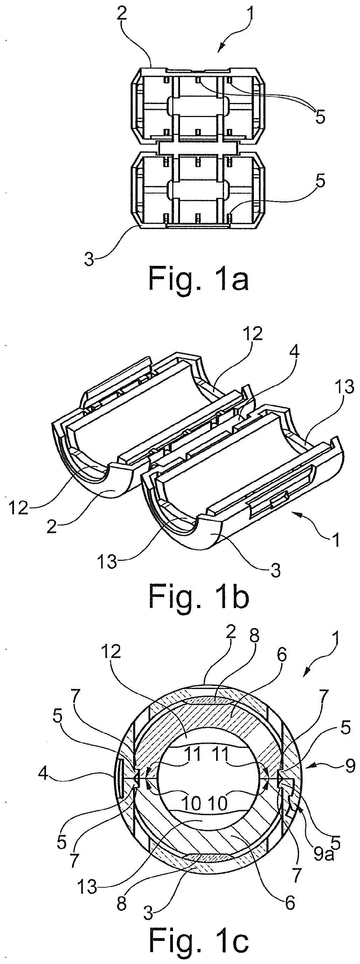

Die Ausführungsform einer Entstörvorrichtung 1 nach den Figuren 1a bis 1c umfasst zwei Gehäusehälften 2, 3, vorzugsweise aus Kunststoff, insbesondere einem Thermoplasten, die über ein Filmscharnier 4 aus z. B. thermoplastischen Elastomer miteinander verbunden sind. Denkbar ist auch eine einstückige Ausgestaltung von Gehäusehälften 2, 3 mit Filmscharnier 4.

Die Gehäusehälften 2, 3 umfassen Halteklauen 5 für Ferritkernhälften 6. Die Ferritkernhälften 6 werden in die Gehäusehälften 2, 3 eingedrückt, sodass die Halteklauen 5 insbesondere in vorgefertigte Ausnehmungen 7 an den Ferritkernhälften 6 einschnappen. Dadurch sind die Ferritkernhälften 6 sicher in den Gehäusehälften 2, 3 gehalten. Damit die Ferritkernhälften elastisch gegen die Halteklauen 5 drücken, ist hinter jeder Ferritkernhälfte 6 ein elastischer Einsatz 8 positioniert. Der elastische Einsatz 8 ist z. B. kissenförmig. Wenn, wie in Figur 1c im Schnitt dargestellt, über eine Verriegelung 9 die Gehäusehälften 2, 3 geschlossen werden, treffen die Ferritkernhälften 6, die vorzugsweise einen leichten Überstand über eine Gehäuseschließkante besitzen, mit ihren Anschlagflächen aufeinander und werden in das Gehäuse gegen eine elastische Kraft der elastischen Einsätze 8 gedrückt. Dadurch kann eine bestmöglich verschlossene Schließlinie der Ferritkernhälften 6 erreicht werden.

Die Verriegelung weist vorzugsweise einen Verriegelungshaken 9a auf. Außerdem sind für ein Fixieren an einem Kabel an den Gehäusehälften 2, 3 Kabelklemmorgane 12, 13 vorgesehen.

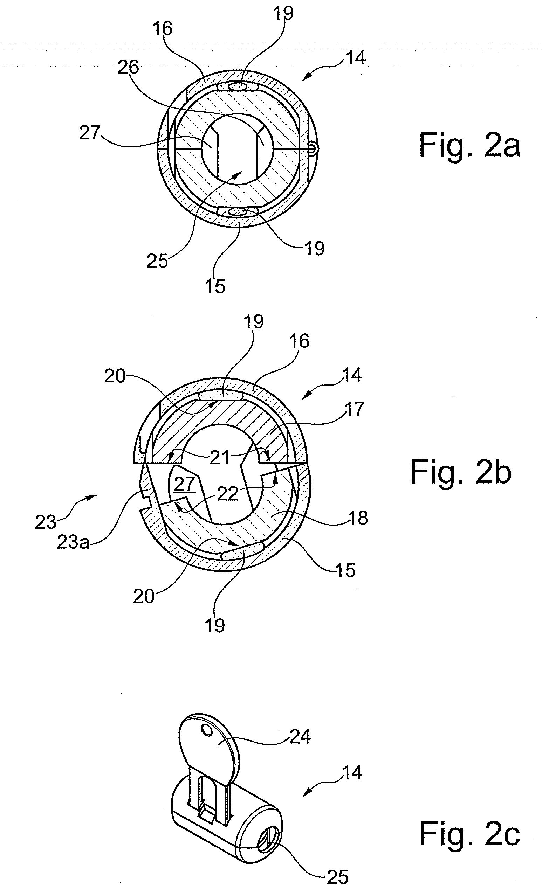

Das Ausführungsbeispiel einer Entstörvorrichtung 14 gemäß der Figuren 2a bis 2c besteht ebenfalls aus zwei Gehäusehälften 15, 16, in welche Ferritkernhälften 17, 18 eingesetzt sind.

Bei dieser Ausführungsform sind keine Halteklauen vorgesehen. Die Fixierung der Ferritkernhälften 17, 18 erfolgt über jeweils eine elastische Einlage 19 in Form einer flexiblen Klebemasse, zwischen den Gehäusehälften 15, 16 und der jeweiligen Rückseite der Ferritkernhälften 17, 18.

Vorzugsweise sind die Ferritkernhälften 17, 18 zur verbesserten Positionierung und Raumgewinnung für die elastischen Einsätze 19 jeweils an der Rückseite mit einer Abflachung 20 versehen.

Durch die elastischen Einsätze 19 in Form einer flexiblen Klebemasse können die Ferritkernhälften 17, 18 nicht nur im Gehäuse fixiert werden, sondern auch so fixiert werden, dass beim Schließen des Gehäuses Anschlagflächen 21, 22, die vorzugsweise etwas über die Schließkante der Gehäusehälften 15, 16 überstehen, elastisch gegeneinander gedrückt werden, sodass ein geschlossener, im Wesentlichen spaltfreier Ferrittubus entsteht, der im Schnitt ringförmig ist.

Zum Verschließen der Gehäusehälften 15, 16 ist eine Verriegelungseinrichtung 23 vorgesehen mit vorzugsweise einem hintergreifenden Schnapparm 23a. Um eine eingerastete Verriegelung zu lösen, kann wie in Figur 2c dargestellt, ein Schlüssel 24 in entsprechende Aussparungen eingesetzt werden, der dann den Schnapparm 23a aus der Rastposition herausdrängt, sodass sich die Gehäusehälften 15, 16 öffnen lassen.

Auch bei dieser Ausführungsform ist vorzugsweise an der jeweiligen Durchtrittsöffnung 25 für ein Durchtreten eines Kabels jeweils ein Kabelklemmorgan 26, 27 vorgesehen.

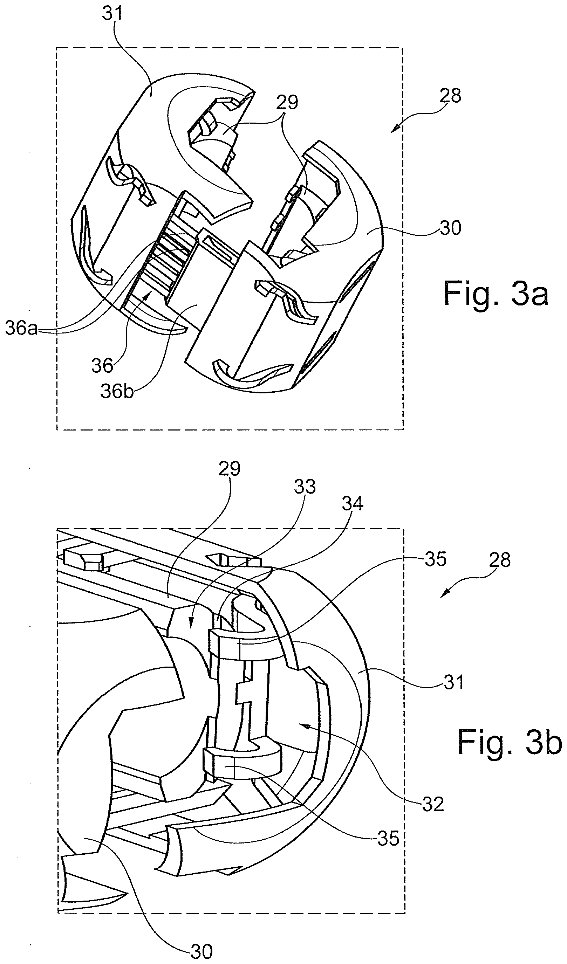

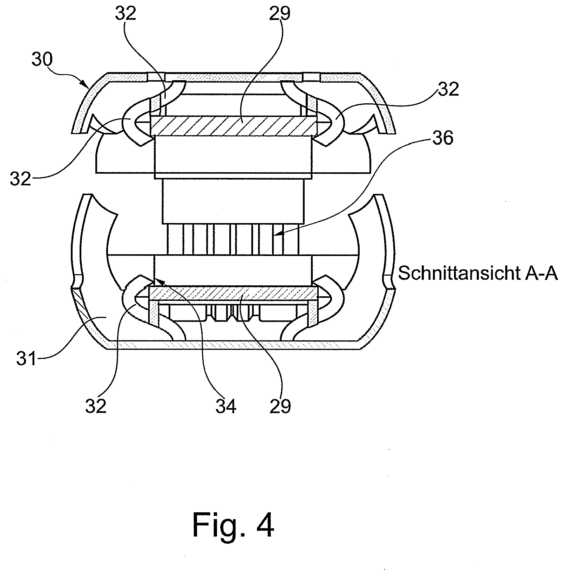

Bei einer weiteren vorteilhaften Ausführungsform einer Entstörvorrichtung 28 nach den Figuren 3a, 3b sowie 4 sind Ferritkernhälften 29 in Gehäusehälften 30, 31 durch

Federarme 32 (s. insbesondere Figur 3b sowie den Schnitt gemäß Figur 4) gehalten. Die Federarme 32, die vorzugsweise gegenüberliegend an den Stirnseiten 33 der Ferritkernhälften 29 auf Ausklinkungen 34 zugreifen, sind, wie insbesondere in Figur 3b ersichtlich ist, mit zwei voneinander beabstandeten Teilarmen 35 ausgestattet. Damit sind die Ferritkernhälften, so wie aus Figur 4 ersichtlich, vollständig federnd auf den Federarmen 32 gelagert und werden, wenn die Gehäusehälften 30, 31 verschlossen sind, federnd nachgiebig zurückgedrängt, sodass eine in vorgegebenem Ausmaß angepresste Stoßlinie entsteht, die keinen Spalt an den Ferritkernhälften aufweist.

Eine weitere Besonderheit der Ausführungsform der Entstörvorrichtung 28 gemäß den Figuren 3a, 3b sowie 4 ist eine Schiebeführung 36, durch welche sich die Gehäusehälften 30, 31 insbesondere linear zusammenschieben lassen.

Damit die Gehäusehälften 30, 31 sicher zusammenhalten, kann die Schiebeführung 36 mit einer Zahnstange an einer Gehäusehälfte ausgestattet sein, die an einem rastenden Gegenpart an der anderen Gehäusehälfte entlangläuft, und so sich die Gehäusehälften schrittweise linear verrasten lassen, bis diese vollständig geschlossen sind. Die Schiebeführung 36 ist vorzugweise aus mehreren Führungsstangen 36a gebildet, die einer Gehäusehälfte zugeordnet sind und in eine Führung 36b an der anderen Gehäusehälfte eingreifen.

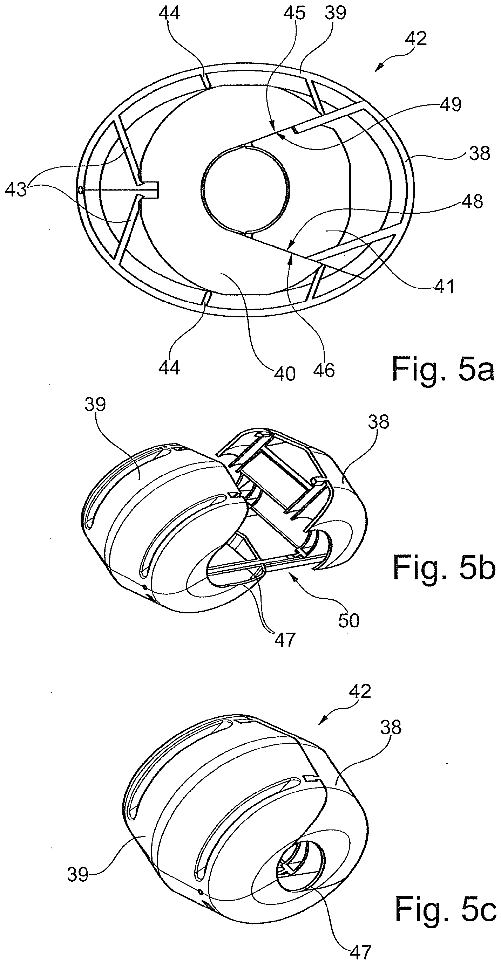

In der Ausführungsform einer Entstörvorrichtung gemäß den Figuren 5a bis 5c sind sowohl Gehäuseteile 38, 39 als auch Ferritkernteile 40, 41 asymmetrisch geteilt. Im Schnitt ist dies in Figur 5a und in der dreidimensionalen Darstellung im geöffneten Zustand des Gesamtgehäuses 42 in Figur 5b besonders anschaulich zu sehen.

Das Gehäuse 42 ist im Schnitt oval. Der Ferritkernteil 40 ist federnd im Gehäuseteil 38 gelagert. Hierzu liegt die Außenseite des Ferritkernteils 40 an nachgiebigen Stegen 43, 44 an. Im geöffneten Zustand steht vorzugsweise die jeweilige Anschlagfläche 45, 46 über eine Schließkante 47 des Gehäuseteils 39 über, sodass der Ferritkernteil 41 beim Schließen des Gehäuses 42 und im geschlossenen Zustand des Gehäuses 42 Druck auf den Ferritkernteil 40 ausübt, sodass die Anschlagflächen 45, 46 des Ferritkernteils 40 als auch die Anschlagflächen 48, 49 des Ferritkernteils 41 im geschlossenen Zustand dicht und möglichst spaltfrei aneinander liegen.

Im Schnitt betrachtet sind die Anschlagflächen 45, 46 des Ferritkernteils trichterförmig und die Anschlagfläche 48, 49 des Ferritkernteils 41 keilförmig, aber passend zu der trichterförmigen Anordnung angeordnet, sodass sich die Anschlagflächen spaltfrei aneinander legen.

Beim Schließen des Gehäuses nach eingelegtem Kabel (nicht dargestellt) wird vorzugsweise der Ferritkernteil 40 durch Nachgeben der Federarme 43, 44 weiter in das Gehäuseteil 39 hinein gedrückt, sodass eine federnde Anlage der Anschlagflächen 45, 46, 47, 48 gewährleistet ist.

Die Gehäuseteile 38, 39 werden vorzugsweise über eine Schiebeführung 50 bei einer Bewegung zueinander geführt. Vorzugsweise verfügt die Schiebeführung über einen Schnappverschluss (nicht dargestellt) oder es ist ein separater Schnappverschluss an den Gehäuseteilen 38, 39 vorgesehen, um die Gehäuseteile 38, 39 so zu verbinden, dass sie im geschlossenen Zustand bleiben.

Denkbar ist auch, dass die Schiebeführung wie die Schiebeführung 36 eine Verzahnung aufweist, die mit einem passenden darin schnappenden Gegenstück des anderen Gehäuseteils zusammen wirkt, um somit ein Verrasten der Gehäuseteile 38, 39 bis hin in die komplett geschlossene Position schrittweise zu ermöglichen.

**Bezugszeichenliste:**

| | | | |
|---|---|---|---|
| 1 | Entstörvorrichtung | 31 | Gehäusehälfte |
| 2 | Gehäusehälfte | 32 | Federarm |
| 3 | Gehäusehälfte | 33 | Stirnseite |
| 4 | Filmscharnier | 34 | Ausklinkung |
| 5 | Halteklaue | 35 | Teilarm |
| 6 | Ferritkernhälfte | 36 | Schiebeführung |
| 7 | Ausnehmung | 36a | Führungsstange |
| 8 | elastischer Einsatz | 36b | Führung |
| 9 | Verriegelung | | |
| 9a | Verriegelungshaken | 38 | Gehäuseteil |
| 10 | Anschlagfläche | 39 | Gehäuseteil |
| 11 | Anschlagfläche | 40 | Ferritkernteil |
| 12 | Kabelklemmorgan | 41 | Ferritkernteil |
| 13 | Kabelklemmorgan | 42 | Gehäuse |
| 14 | Entstörvorrichtung | 43 | Steg |
| 15 | Gehäusehälfte | 44 | Steg |
| 16 | Gehäusehälfte | 45 | Anschlagfläche |
| 17 | Ferritkernhälfte | 46 | Anschlagfläche |
| 18 | Ferritkernhälfte | 47 | Schließkante |
| 19 | elastischer Einsatz | 48 | Anlagefläche |
| 20 | Abflachung | 49 | Anlagefläche |
| 21 | Anschlagfläche | 50 | Schiebeführung |
| 22 | Anschlagfläche | | |
| 23 | Verriegelungseinrichtung | | |
| 23a | Schnapparm | | |
| 24 | Schlüssel | | |
| 25 | Durchtrittsöffnung | | |
| 26 | Kabelklemmorgan | | |
| 27 | Kabelklemmorgan | | |
| 28 | Entstörvorrichtung | | |
| 29 | Ferritkernhälfte | | |
| 30 | Gehäusehälfte | | |

## Patentansprüche

1. Vorrichtung (1, 14, 28, 37) zum Absorbieren bzw. Reduzieren von Signalstörungen auf einem elektrischen Leiter, insbesondere in einem Kabel, mit einer Durchführungsöffnung, die zur Durchführung des elektrischen Leiters vorgesehen ist, mit einer Dämpfungseinrichtung, die ein mehrteiliges, insbesondere aus zwei Dämpfungsteilen bestehendes ringförmiges Dämpfungselement aus einem Dämpfungsmaterial umfasst, das elektromagnetische Störsignale, insbesondere Rauschsignale dämpft, mit einem Gehäuse, in dem sich das Dämpfungselement unterbringen lässt und das zur Anbringung des Dämpfungselements am elektrischen Leiter vorgesehen ist, wobei das Gehäuse (42) mehrere, insbesondere zwei schalenförmige Gehäuseteile (2, 3, 15, 16, 30, 31) umfasst, wobei in einem zusammengesetzten Zustand der Vorrichtung das Dämpfungselement im Gehäuse (42) einen in der Durchführungsöffnung angeordneten Leiter ringförmig umgibt, **dadurch gekennzeichnet, dass** ein erstes Gehäuseteil (2, 3, 15, 16, 30, 31) wenigstens zwei nachgiebige, armförmige Stützelemente (32) aufweist, die zumindest an ein erstes Dämpfungsteil (29) derart angepasst sind, dass das erste Dämpfungsteil (29) von den beiden armförmigen Stützelementen (32) gefedert gehalten ist und in einem zusammengesetzten Zustand der Vorrichtung (1, 14, 28, 37) an einem zweiten Dämpfungsteil (29) in einer vorgegebenen Position anliegt, wobei die Dämpfungsteile (29) derart in den Gehäuseteilen (2, 3, 15, 16, 30, 31) positioniert sind, dass ein Überstand im Hinblick auf eine Schließkante der Gehäuseteile (2, 3, 15, 16, 30, 31) entsteht, dass das erste Dämpfungsteil (29) im zusammengesetzten Zustand der Vorrichtung (1, 14, 28, 37) federnd zurückgedrängt wird und die Dämpfungsteile (29) dicht aneinanderliegend positioniert sind.

2. Vorrichtung (1, 14, 28, 37) nach nach Anspruch 1, **dadurch gekennzeichnet, dass** ein erstes Gehäuseteil (2, 3, 15, 16, 30, 31) nachgiebige, armförmige Stützelemente (32) aufweist, die an das erste Dämpfungsteil (29) derart angepasst sind, dass das erste Dämpfungsteil (29) in einem zusammengesetzten Zustand der Vorrichtung (1, 14, 28, 37) an einem zweiten Dämpfungsteil (29) in einer vorgegebenen Position anliegt, dass das zweites Dämpfungsteil (29) am zweiten Gehäuseteil (2, 3, 15, 16, 30, 31) durch weitere nachgiebige, armförmige Stützelemente (32) gehalten ist, so dass die nachgiebigen, armförmigen Stützelemente (32) an Stirnseiten (33) der beiden Dämpfungsteile (29) auf Ausklinkungen (34) zugreifen, so dass die Dämpfungsteile (29) vollständig federnd auf den nachgiebigen, armförmigen Stützelemente (32) gelagert sind, wobei bei geschlossenen Gehäuseteilen (2, 3, 15, 16, 30, 31) die Dämpfungsteile (29) federnd nachgiebig zurückgedrängt sind, sodass eine in vorgegebenem Ausmaß angepresste Stoßlinie entsteht, die keinen Spalt an den Dämpfungsteilen (29) aufweist.

3. Vorrichtung nach einem der vorgenannten Ansprüche, **dadurch gekennzeichnet, dass** Verschlussmittel (9, 9a, 23) vorgesehen sind, mit denen sich das Gehäuse nach einem Zusammensetzen der Gehäuseteile verschließen lässt.

4. Vorrichtung nach einem der vorgenannten Ansprüche, **dadurch gekennzeichnet, dass** zwei der schalenförmigen Gehäuseteile (2, 3, 15, 16) über ein Scharnier miteinander beweglich verbunden sind.

5. Vorrichtung nach einem der vorgenannten Ansprüche, **dadurch gekennzeichnet, dass** an zwei der schalenförmigen Gehäuseteile Verschlussmittel (9, 9a, 23) ausgebildet sind, mit denen sich die Gehäuseteile aneinander anschlagend verschließen lassen.

6. Vorrichtung nach einem der vorgenannten Ansprüche, **dadurch gekennzeichnet, dass** mit den Verschlussmitteln (9, 9a, 23) ein Rastverschluss ausgebildet ist.

7. Vorrichtung nach einem der vorgenannten Ansprüche, **dadurch gekennzeichnet, dass** eines der Gehäuseteile eine Einstecköffnung aufweist, die zum Einstecken eines darauf abgestimmten Schlüssels (24) vorgesehen ist, mit dem sich die Verschlussmittel (23) entriegeln lassen.

8. Vorrichtung nach einem der vorgenannten Ansprüche, **dadurch gekennzeichnet, dass** die schalenförmigen Gehäuseteile (2, 3, 15, 16) als zwei Rohrhälften ausgebildet sind, die an ihren Enden jeweils einen Bund aufweisen, um die Durchführungsöffnung zu definieren.

9. Vorrichtung nach einem der vorgenannten Ansprüche, **dadurch gekennzeichnet, dass** am ersten Dämpfungselement (6) Rasteingriffe (7) ausgebildet sind, die für einen Eingriff von Halteklauen (5) an einer Innenseite des ersten Gehäuseteils vorgesehen sind, mit denen das erste Dämpfungsteil (6) nach einem Eindrücken im ersten Gehäuseteil (2) zurückgehalten ist.

10. Vorrichtung nach einem der vorgenannten Ansprüche, **dadurch gekennzeichnet, dass** die Gehäuseteile (30, 31, 38, 39) eine lineare Schiebeführung umfassen, über welche sich die Gehäuseteile (30, 31, 38, 39) linear zusammenschieben lassen.

## Claims

1. Device (1, 14, 28, 37) for absorbing or reducing signal interference on an electrical conductor, in particular in a cable, with a through opening which is provided for feeding through the electrical conductor, comprising a damping device, which comprises a multipart, annular damping element, consisting in particular of two damping parts made from a damping material, which damps electromagnetic interference signals, in particular noise signals, with a housing in which the damping element can be accommodated and which is provided for attaching the damping element to the electrical conductor, wherein the housing (42) comprises a plurality, in particular two, shell-like housing parts (2, 3, 15, 16, 30, 31), wherein in an assembled state of the device the damping element in the housing (42) annularly surrounds a conductor arranged in the through opening, **characterised in that** a first housing part (2, 3, 15, 16, 30, 31) comprises at least two flexible arm-like support elements (32) which are adjusted at least to a first damping part (29) such that the first damping part (29) is held spring-like by the two arm-like support elements (32) and in an assembled state of the device (1, 14, 28, 37) bears on a second damping part (29) in a predefined position, wherein the damping parts (29) are positioned in the housing parts (2, 3, 15, 16, 30, 31) such that there is an overhang with regard to a closing edge of the housing parts (2, 3, 15, 16, 30, 31), **in that** the first damping part (29) in the assembled state of the device (1, 14, 28, 37) is forced back resiliently and the damping parts (29) are positioned tightly against one another.

2. Device (1, 14, 28, 37) according to claim 1, **characterised in that** a first housing part (2, 3, 15, 16, 30, 31) comprises flexible, arm-like support elements (32) which are adjusted to the first damping part (29) such that the first damping part (29) in an assembled state of the device (1, 14, 28, 37) bears on a second damping part (29) in a predefined position, **in that** the second damping part (29) is held on the second housing part (2, 3, 15, 16, 30, 31) by additional flexible, arm-like support elements (32), so that the flexible arm-like support elements (32) engage with end sides (33) of the two damping parts (29) on notches (34), so that the damping parts (29) are mounted completely flexibly on the elastic, arm-like support elements (32), wherein with closed housing parts (2, 3, 15, 16, 30, 31) the damping parts (29) are forced back in a flexible elastic way so that a joint is formed pressed to a predefined extent which does not have a gap on the damping parts (29).

3. Device according to any of the preceding claims, **characterised in that** locking means (9, 9a, 23) are provided, by means of which the housing can be locked after assembling the housing parts.

4. Device according to any of the preceding claims, **characterised in that** two of the shell-like housing parts (2, 3, 15, 16) are joined together movably by means of a hinge.

5. Device according to any of the preceding claims , **characterised in that** on two of the shell-like housing parts locking means (9, 9a, 23) are formed, by means of which the housing parts can locked together bearing against one another.

6. Device according to any of the preceding claims, **characterised in that** a snap-in lock is formed by means of the locking means (9, 9a, 23).

7. Device according to any of the preceding claims, **characterised in that** one of the housing parts comprises an insertion opening which is provided for inserting a key (24) matching the latter, by means of which the locking means (23) can be unlocked.

8. Device according to any of the preceding claims, **characterised in that** the shell-like housing parts (2, 3, 15, 16) are designed as two pipe halves, which have a collar at each end for defining the through opening.

9. Device according to any of the preceding claims, **characterised in that** on the first damping element (6) catches (7) are formed, which are provided for the engagement retaining claws (5) with an inner side of the first housing part, by means of which the first damping part (6) is held back after pushing into the first housing part (2).

10. Device according to any of the preceding claims, **characterised in that** the housing parts (30, 31, 38, 39) comprise a linear sliding guide, by means of which the housing parts (30, 31, 38, 39) can be pushed together linearly.

## Revendications

1. Dispositif (1, 14, 28, 37) pour absorber ou réduire des perturbations de signal dans une conduite électrique, en particulier un câble, comportant une ouverture de passage prévue pour le passage de la conduite électrique, un dispositif atténuateur comprenant un élément atténuateur annulaire en plusieurs pièces, en particulier en deux pièces d'atténuateur, et constitué d'un matériau atténuateur lequel dispositif atténuateur atténue les signaux parasites électromagnétiques, en particulier des signaux de bruit, un boîtier dans lequel peut être logé l'élément atténuateur et qui est prévu pour fixer l'élément atténuateur sur la conduite électrique, le boîtier (42) comprenant plusieurs pièces de boîtier en forme de coque (2, 3, 15, 16, 30, 31), en particulier deux, l'élément atténuateur, à l'état monté du dispositif, entourant de façon annulaire dans le boîtier (42) une conduite disposée dans l'ouverture de passage, **caractérisée en ce qu'**une première pièce de boîtier (2, 3, 15, 16, 30, 31) est munie d'au moins deux éléments support (32) flexibles en forme de bras qui sont adaptés à au moins une pièce d'atténuateur (29) de telle sorte que la première pièce d'atténuateur (29) est retenue de façon élastique par les deux éléments support (32) en forme de bras, et repose, à l'état monté du dispositif (1, 14, 28, 37), sur une deuxième pièce d'atténuateur (29) dans une position prédéterminée, les pièces d'atténuateur (29) étant positionnées dans les pièces de boîtier (2, 3, 15, 16, 30, 31) de telle sorte qu'il se forme une projection par rapport à une arête de fermeture des pièces de boîtier (2, 3, 15, 16, 30, 31), que la première pièce d'atténuateur (29), à l'état monté du dispositif (1, 14, 28, 37) est repoussée élastiquement et les pièces d'atténuateur (29) sont positionnées étroitement en appui l'une contre l'autre.

2. Dispositif (1, 14, 28, 37) selon la revendication 1, **caractérisé en ce qu'**une première pièce de boîtier (2, 3, 15, 16, 30, 31) est munie d'éléments support (32) flexibles en forme de bras qui sont adaptés de telle sorte à la première pièce d'atténuateur (29) que la première pièce d'atténuateur (29), à l'état monté du dispositif (1, 14, 28, 37), est appliquée contre une deuxième pièce d'atténuateur (29) dans une position prédéterminée, que la deuxième pièce d'atténuateur (29) est retenue dans la deuxième partie de boîtier (2, 3, 15, 16, 30, 31) par d'autres éléments support (32) flexibles en forme de bras, de sorte que les éléments support (32) flexibles en forme de bras saisissent les deux pièces d'atténuateur par le côté frontal (33) sur des mortaises (34), de sorte que les parties d'atténuateur (29) sont logées sur les éléments support (32) flexibles en forme de bras de façon totalement élastique, les pièces d'atténuateurs (29) étant repoussées de façon flexible et élastique lorsque les pièces de boîtier (2, 3, 15, 16, 30, 31) sont fermées, de sorte qu'il se forme une ligne d'about serrée dans des proportions prédéfinies qui ne présente aucun interstice sur les pièces d'atténuateur (29).

3. Dispositif selon l'une des revendications précédentes, **caractérisé en ce que** des moyens de verrouillage (9, 9a, 23) sont prévus avec lesquels le boîtier peut être fermé après assemblage des pièces de boîtier.

4. Dispositif selon l'une des revendications précédentes, **caractérisé en ce que** deux des pièces de boîtier en forme de coque (2, 3, 15, 16) sont reliées de façon mobile l'une à l'autre par l'intermédiaire d'une charnière.

5. Dispositif selon l'une des revendications précédentes, **caractérisé en ce que** des moyens de verrouillage (9, 9a, 23) sont formés sur deux des pièces de boîtier en forme de coque, avec lesquels les pièces de boîtier peuvent être verrouillées en étant en butée l'une contre l'autre.

6. Dispositif selon l'une des revendications précédentes, **caractérisé en ce qu'**une fermeture à encliquetage est formée avec les moyens de verrouillage (9, 9a, 23).

7. Dispositif selon l'une des revendications précédentes, **caractérisé en ce que** l'une des pièces de boîtier est munie d'une ouverture d'insertion prévue pour l'insertion d'une clé (24) adaptée à celle-ci et avec laquelle les moyens de verrouillage (23) peuvent être déverrouillés.

8. Dispositif selon l'une des revendications précédentes, **caractérisé en ce que** les pièces de boîtier en forme de coque (2, 3, 15, 16) sont conçues sous la forme de deux moitiés de tube munies à chacune de leurs extrémités d'une collerette pour définir l'ouverture de passage.

9. Dispositif selon l'une des revendications précédentes, **caractérisé en ce que** des prises d'encliquetage (7) sont formées sur le premier élément atténuateur (6), lesquelles prises sont prévues pour l'engrènement de griffes de retenue (5) situées sur une face interne de la première pièce de boîtier et avec lesquelles la première pièce d'atténuateur (6) est retenue après avoir été poussée dans la première pièce de boîtier (2).

10. Dispositif selon l'une des revendications précédentes, **caractérisé en ce que** les pièces de boîtier (30, 31, 38, 39) comprennent un guide de coulissement linéaire par l'intermédiaire duquel les pièces de boîtier (30, 31, 38, 39) peuvent être poussées linéairement les unes contre les autres.
